(19) Europäisches Patentamt
European Patent Office
Office européen des brevets

(11) **EP 1 424 598 B1**

(12) **EUROPEAN PATENT SPECIFICATION**

(45) Date of publication and mention
of the grant of the patent:
**09.04.2008 Bulletin 2008/15**

(51) Int Cl.:
***G03F 7/20*** *(2006.01)*

(21) Application number: **03257447.7**

(22) Date of filing: **26.11.2003**

(54) **Lithographic projection apparatus and device manufacturing method**

Lithographischer Apparat und Verfahren zur Herstellung einer Vorrichtung

Appareil lithographique et méthode de fabrication d'un dispositif

(84) Designated Contracting States:
**DE FR GB IT NL**

(30) Priority: **27.11.2002 EP 02258164**

(43) Date of publication of application:
**02.06.2004 Bulletin 2004/23**

(73) Proprietor: **ASML Netherlands B.V.
5504 DR Veldhoven (NL)**

(72) Inventors:
• **Bleeker, Arno Jan
5563 CE Westerhoven (NL)**

• **Benschop, Jozef Petrus Henricus
5501 EV Veldhoven (NL)**

(74) Representative: **Leeming, John Gerard
J.A. Kemp & Co.
14 South Square
Gray's Inn
London WC1R 5JJ (GB)**

(56) References cited:
**EP-A- 1 115 031        US-A- 5 296 891
US-B1- 6 379 867**

**Description**

The present invention relates to a lithographic projection apparatus comprising:

- a radiation system for supplying a pulsed projection beam of radiation;
- programmable patterning means for patterning the projection beam according to a desired pattern;
- a substrate table for holding a substrate;
- a projection system for projecting the patterned beam onto a target portion of the substrate; and
- means for moving the substrate relative to the projection system.

Lithographic projection apparatus are used in the manufacture of integrated circuits (ICs), flat panel displays and other devices involving fine structures. The programmable patterning means generates a pattern corresponding to an individual layer of, for example, the IC, and this pattern is imaged onto a target portion (*e.g.* comprising part of, one or several dies) on a substrate (*e.g.* silicon wafer or glass plate) that has been coated with a layer of radiation-sensitive material (resist).

Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. These transfer procedures result in a patterned layer of resist on the substrate. One or more pattern steps, such as deposition, etching, ion-implantation (doping), metallization, oxidation, chemo-mechanical polishing, etc., follow, each of which is intended to finish, create or modify a layer of the device. If several layers are required, then the whole procedure, or a variant thereof, is repeated for each new layer. Eventually, an array of devices will be present on the substrate (wafer). These devices are then separated from one another by a technique such as dicing or sawing, whence the individual devices can be mounted on a carrier, connected to pins, etc.. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

US 6,379,867 discloses a photolithography system in which the position of a patterned beam of radiation relative to the substrate on which it is incident can be moved in an oscillating fashion to enable small position offsets between subsequent exposures; in order to prevent blurring a pulsed rotation source may be used.

In presently known lithographic projection apparatus using programmable patterning means, the substrate table is scanned below the patterned projection beam. A pattern is set on the programmable patterning means and is then exposed on the substrate during a pulse of the radiation system. In the interval before the next pulse of the radiation system, the substrate table moves the substrate to the position required to expose the next target portion of the substrate and the pattern on the programmable patterning means is updated. This process is repeated until a complete line on the substrate has been scanned whereupon a new line is started. During the small but finite time that the pulse of the radiation system lasts, the substrate table will consequently have moved a small but finite distance. Previously, this has not been a problem for lithographic projection apparatus using programmable patterning means because the size of the substrate movement during the pulse has been small relative to the size of the feature being exposed on the substrate. Therefore the error produced was not significant. However, as the features being produced on substrates become smaller, the error becomes more significant.

It is an object of the present invention to reduce the errors caused by the movement of the substrate during the pulse of the radiation system.

This and other objects are achieved according to the invention in a lithographic apparatus according to claim 1.

The means for moving the patterned projection beam allows the projection beam to remain more accurately aligned on the substrate, thus reducing any errors caused by the movement of the substrate relative to the projection system during the pulse of the radiation system.

Preferably the substrate is moved at a constant velocity relative to the projection system during a series of pulses of the radiation system and the intervals in between the pulses. The means for moving the patterned projection beam is then used to move the patterned projection beam in synchronism with the movement of the substrate for the duration of at least one pulse of the radiation system. Having the substrate moving at a constant velocity reduces the complexity of the substrate table and the positional drivers associated with it; but, by moving the patterned projection beam in synchronism with the movement of the substrate, the consequent errors are reduced.

The patterned projection beam may be moved in synchronism with the movement of the substrate during a plurality of pulses. This enables the images of the programmable patterning means to be projected onto the same part of the substrate a plurality of times. This may be done, for example, if the intensity of the pulse of the patterned projection beam is not sufficient to produce a complete exposure on the substrate. Moving the patterned projection beam in synchronism with the substrate reduces the occurrence of overlay errors between subsequent exposures of the pattern on the substrate.

Successive patterns on the programmable patterning means that are exposed on the substrate by each pulse may be different. For example, corrections may be made in subsequent pulses to offset errors in a first pulse. Alternatively, changes in the pattern may be used to produce gray scale images for some of the features (for example, by only exposing those features for a proportion of the total number of pulses imaged onto a given part of the substrate).

Additionally or alternatively the intensity of the patterned projection beam, the illumination of the programmable patterning means or the pupil filtering may be changed for one of the pulses of the radiation system that are projected onto the same part of the substrate. This may be used, for example, to increase the number of gray scales that may be generated using the technique described in the preceding paragraph or may be used to optimise different exposures for features oriented in different directions.

The means for moving the patterned beam relative to the projection system may comprise a layer of electro-optical material through which the patterned projection beam passes. A control system may be provided to apply a control voltage across the electro-optical material, thereby changing the birefringence of the electro-optical material. The change in birefringence of the electro-optical material in response to changes in the control voltage moves the part of the patterned projection beam emitted from it that is polarized in a given direction. Therefore the patterned projection beam may be polarized such that all of the patterned projection beam is moved by changes in the birefringence of the electro-optical material.

Alternatively, the means for moving the patterned projection beam relative to the projection system may comprise a second layer of electro-optical material through which the patterned projection beam also passes. The second layer of electro-optical material is oriented such that by applying a control voltage to the second layer, changing its birefringence, the second layer moves that part of the patterned projection beam that is polarized in the opposite direction to that which is moved by the first layer. Consequently, the entirety of the patterned projection beam may be moved without the patterned projection beam needing to be polarized.

An alternative means for moving the patterned projection beam relative to the projection system comprises a reflective surface mounted such that the angle between the surface and the patterned projection beam incident on it can vary during the pulse of the radiation system. As the angle changes, so the position of the beam reflected from it is moved. A preferential means of embodying this system is a rotating prism with a polygonal cross-section. The edge faces form the reflective surface. As the prism rotates each face in turn reflects the patterned projection beam. Whilst the patterned projection beam is incident on each face, the angle of each face relative to the patterned projection beam changes. By careful tuning of the speed of rotation of the prism with respect to the pulse frequency of the radiation system and correct selection of the size of the prism, the required control of the movement of the patterned projection beam can be effected. An advantage of this system is that it does not require the radiation beam to be polarized and it can be effected in an apparatus that solely uses reflective components.

According to a further aspect of the invention there is provided:

a device manufacturing method comprising the steps of:

- providing a substrate that is at least partially covered by a layer of radiation sensitive material;
- providing a pulsed projection beam of radiation using a radiation system;
- using programmable patterning means to endow the projection beam with a pattern in its cross-section;
- projecting the patterned beam of radiation onto a target portion of the layer of radiation-sensitive material,
- moving the substrate relative to the projection system to target successive portions of the layer of radiation-sensitive material,

characterized by moving the patterned projection beam that is projected onto the substrate relative to the projection system during at least one pulse of the radiation system in synchronism with the movement of the substrate such that the projection beam is substantially stationary relative to the substrate during said at least one pulse.

The term "programmable patterning means" as here employed should be broadly interpreted as referring to any means that can be used to endow an incoming radiation beam with a patterned cross-section, so that a desired pattern can be created in a target portion of the substrate; the terms "light valve" and "Spatial Light Modulator" (SLM) can also be used in this context. Examples of such patterning means include:

- A programmable mirror array. This may comprise a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate spatial filter, the said undiffracted light can be filtered out of the reflected beam, leaving only the diffracted light to reach the substrate; in this manner, the beam becomes patterned according to the addressing pattern of the matrix-addressable surface. An array of grating light valves (GLV) can also be used in a corresponding manner. Each GLV is comprised of a plurality of reflective ribbons that can be deformed relative to one another to form a grating that reflects incident light as diffracted light. A further alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the programmable patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096.

- A programmable LCD array. An example of such a construction is given in United States Patent US 5,229,872.

It should be appreciated that where pre-biasing of features, optical proximity correction features, phase variation techniques and multiple exposure techniques are used, the pattern "displayed" on the programmable patterning means may differ substantially from the pattern eventually transferred to a layer of or on the substrate.

For the sake of simplicity, the projection system may be referred to as the "lens"; however, this term should be broadly interpreted as encompassing various types of projection system, including refractive optics, reflective optics, catadioptric systems and micro lens arrays, for example. It is to be understood that the term "projection system" as used in this application simply refers to any system for transferring the patterned beam from the programmable patterning means to the substrate. The radiation system may also include components operating according to any of these design types for directing, shaping or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, thin film transistor liquid crystal displays, printed circuit boards (PCBs), etc.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams. example only, with reference to the accompanying schematic drawings, in which:

Figure 1 depicts a lithographic projection apparatus according to an embodiment of the invention;
Figure 2 depicts a first embodiment of the means for moving the patterned projection beam according to the present invention;
Figure 3 depicts a second embodiment of the means for moving the patterned projection beam according to the present invention;
Figure 4 depicts a third embodiment of the means for moving the patterned projection beam according to the present invention; and
Figure 5 depicts a variant of the embodiment shown in Figure 4.

In the Figures, corresponding reference symbols indicate corresponding parts.

Embodiment 1

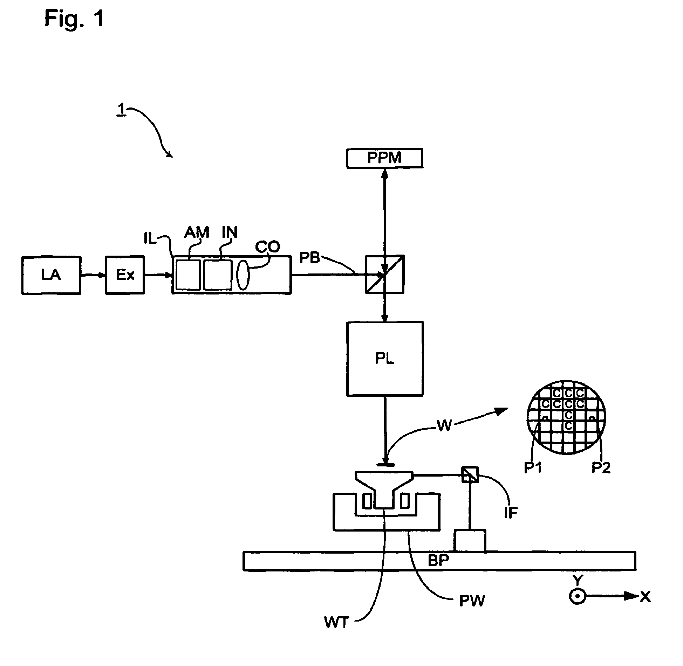

Figure 1 schematically depicts a lithographic projection apparatus according to a particular embodiment of the invention. The apparatus comprises:

- a radiation system Ex, IL, for supplying a projection beam PB of radiation (*e.g.* UV radiation), which in this particular case also comprises a radiation source LA;

- a programmable patterning means PPM (e.g. a programmable mirror array) for applying a pattern to the projection beam; in general the position of the programmable patterning means will be fixed relative to item PL; however it may instead be connected to a positioning means for accurately positioning it with respect to item PL;
- an object table (substrate table) WT provided with a substrate holder for holding a substrate W (*e.g.* a resist-coated silicon wafer), and connected to positioning means for accurately positioning the substrate with respect to item PL;
- a projection system ("lens") PL (*e.g.* a quartz and/or CaF$_2$ lens system or a catadioptric system comprising lens elements made from such materials, or a mirror system) for projecting the patterned beam onto a target portion C (*e.g.* comprising one or more dies) of the substrate W; the projection system may project an image of the programmable patterning means onto the substrate; alternatively, the projection system may project images of secondary sources for which the elements of the programmable patterning means act as shutters; the projection system may also comprise a micro lens array (known as an MLA), *e.g.* to form the secondary sources and to project microspots onto the substrate.

As here depicted, the apparatus is of a reflective type (*i.e.* has a reflective programmable patterning means). However, in general, it may also be of a transmissive type, for example (*i.e.* with a transmissive programmable patterning means).

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the programmable patterning means PPM has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the programmable patterning means PPM. Having been reflected by the programmable patterning means PPM, the beam PB passes through the projection system PL, which focuses the beam PB onto a target portion C of the substrate W. With the aid of the positioning means (and interferometric measuring means IF), the substrate table WT can be moved accurately, *e.g.* so as to position different target portions C in the path of the beam PB. Where used, the positioning means for the programmable patterning means can be used to accurately correct the position of the programmable patterning means PPM with respect to the path of the beam PB, *e.g.* during a scan. In general, movement of the object table WT is realized with the aid of a long-stroke module (coarse positioning) and a short-stroke module (fine positioning), which are not explicitly depicted in Figure 1. A similar system may also be used to position the programmable patterning means. It will be appreciated that the projection beam may alternatively/ additionally be moveable while the object table and/or the programmable patterning means may have a fixed position to provide the required relative movement.

Although the lithography apparatus according to the invention is herein described as being for exposing a resist on a substrate, it will be appreciated that the invention is not limited to this use and the apparatus may be used to project a patterned projection beam for use in resistless lithography.

The depicted apparatus can be used in the following manner:

In pulse mode, the programmable patterning means is kept essentially stationary and the entire pattern is projected onto a target portion C of the substrate using a pulsed radiation source. The substrate table WT is moved with an essentially constant speed such that the projection beam PB is caused to scan a line across the substrate W. The pattern on the programmable patterning means is updated as required between pulses of the radiation system and the pulses are timed such that successive target portions C are exposed at the required locations on the substrate. Consequently, the projection beam can scan across the substrate W to expose the complete pattern for a strip of the substrate. The process is repeated until the complete substrate has been exposed line by line. Different modes may also be used.

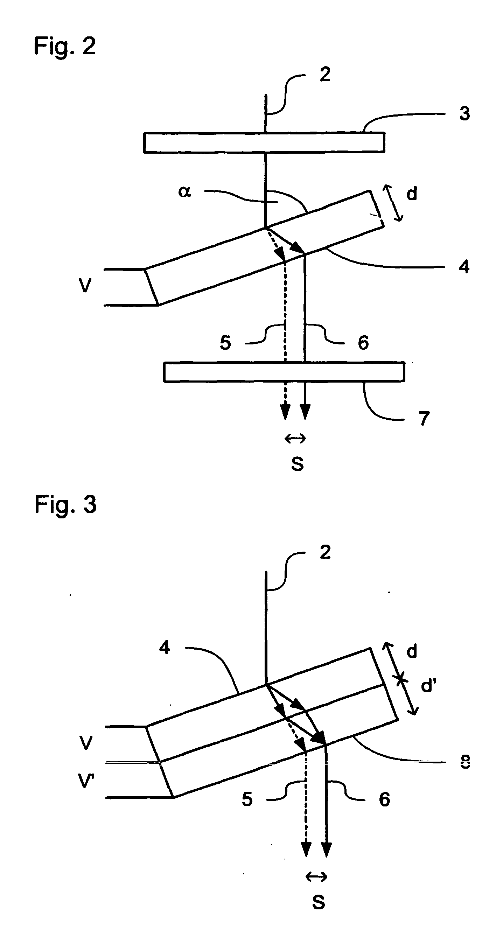

Figure 2 shows, schematically, a means for shifting the patterned projection beam. As shown, the patterned projection beam 2 passes through a polarizing filter 3. The patterned projection beam then passes through a layer of electro-optical material 4. A voltage V applied to the electro-optical material 4 changes its birefringence as required. When no voltage is applied, the patterned projection beam follows the path denoted 5. When a voltage is applied to the electro-optical material 4 the patterned projection beam is shifted to the path denoted 6.

After the electro-optical material, the patterned projection beam may then be passed through a quarter wavelength plate 7, for example, to circularly-polarize the patterned projection beam if required. Alternatively the patterned projection beam could remain linearly polarized or could be de-polarized. The optical axis of the electro-optical material 4 is oriented such that the polarized projection beam is shifted by the birefringence of the electro-optical material 4. The shift S produced by applying a voltage to the electro=optical material 4 can be determined by the following equation:

$$S = d \cdot \sin\alpha \cdot \cos\alpha \cdot \left( \frac{1}{\sqrt{n_1^2 - \sin^2\alpha}} - \frac{1}{\sqrt{n_0^2 - \sin^2\alpha}} \right) \qquad [1]$$

where d is the thickness of the layer of electro-optical material, $\alpha$ is the angle between the patterned projection beam and the surface of the electro-optical material, $N_0$ is the ratio of the refractive index of the environment in which the apparatus functions to the refractive index of the electro-optical material when no voltage is applied and $n_1$ is the corresponding ratio of the refractive indices when a given voltage has been applied to the electro-optical material. Consequently, as the voltage applied to the electro-optical material is changed, the shift S changes. By applying a gradually changing voltage, the patterned projection beam can be caused to gradually shift. By applying an appropriately shaped signal to the electro-optical material the patterned projection beam can be caused to scan in synchronism with the substrate as it moves during the short time of a pulse of the radiation system. Consequently, the errors in the placement of features on the substrate are reduced.

Although as here shown the patterned projection beam 2 is polarized by means of a polarizing filter 3, this need not be the case. In particular, the patterned projection beam 2 may already be polarized, for example, as a result of the programmable patterning means or because the radiation source inherently produces polarized radiation.

The electro-optical layer may be formed from any well-known electro-optical materials, such as ADP, AD*P, KDP and KD*P. In order to obtain the best response from the electro-optical material, it is preferably operated close to, but above, the Curie temperature of the material used. The Curie temperature is generally lower than the ambient temperature for the apparatus. The KDP for example has a Curie temperature of 123 K, KD*P has a Curie temperature variously reported as 213 or 222 K and ADP has a Curie temperature of 148 K. Consequently a temperature controlled cooling unit (not shown) may be provided to cool the electro-optical layer.

Embodiment 2

Figure 3 shows an alternative embodiment of the present invention. This embodiment is similar to the first embodiment and the description of corresponding features will not be repeated. In this embodiment, a second layer of electro-optical material 8 is provided. The direction of the optical axis of the second layer 8 is perpendicular to the optical axis of the first layer. Consequently, when a voltage V is applied to the first layer 4, radiation in the patterned projection beam that is polarized in a first direction is shifted and when a voltage V' is applied to the second layer 8, radiation that is polarized in a second, orthogonal, direction is shifted. Therefore, by simultaneously applying voltages V, V' to both layers of electro-optical material 4, 8 the entire patterned projection beam 2 is shifted, without the need for it to be polarized.

The shift produced by the second layer 8 of electro-optical material can be determined using Equation 1 given above. Some calibration may be required to ensure that both polarizations of the radiation are shifted by the same amount. Slight differences in the thicknesses D, D' of the two layers of electro-optical material 4, 8 can be compensated for by adjustments of either voltage V or voltage V'. It has been found that a 7kV voltage change across a layer of electro-optical material of 0.7 mm thickness produces a 50 nm shift.

Embodiment 3

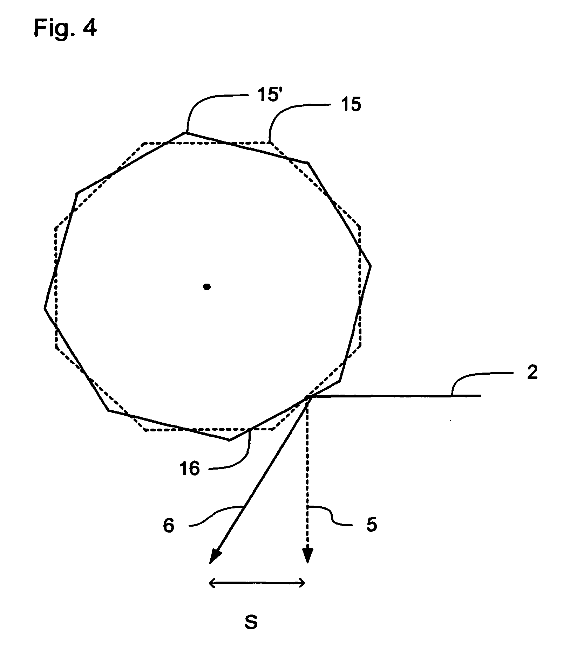

Figure 4 shows an alternative embodiment of the present invention. In this case, the means for shifting the patterned projection means 2 is provided by a rotating prism 15, here shown in cross section that may be located in the back focal plane of the lithographic apparatus. The prism has a plurality of faces 16 that are reflective to the patterned projection beam 2. Figure 4 shows the situation at a first time point when the prism 15 is in a first position and at a second time point when the prism 15' is in a second position. As the prism rotates the angle at which the patterned projection beam 2 is incident on the reflective face 16 of the prism changes. Correspondingly, the angle at which the patterned projection beam 5, 6 radiates from the reflective face 16 also changes. As shown, the difference in angles between the reflected patterned projection beam 5 at the first time point and the reflected patterned projection beam 6 at the second time point produces a shift S where the patterned projection beam is incident on the substrate. By careful timing of the rotation of the prism 15, the patterned projection beam 2 can be made to scan in synchronism with the moving substrate for the duration of a pulse of radiation. In the interval between pulses of radiation the prism 15 rotates to present a different face 16 at the start of the subsequent pulse of the radiation system.

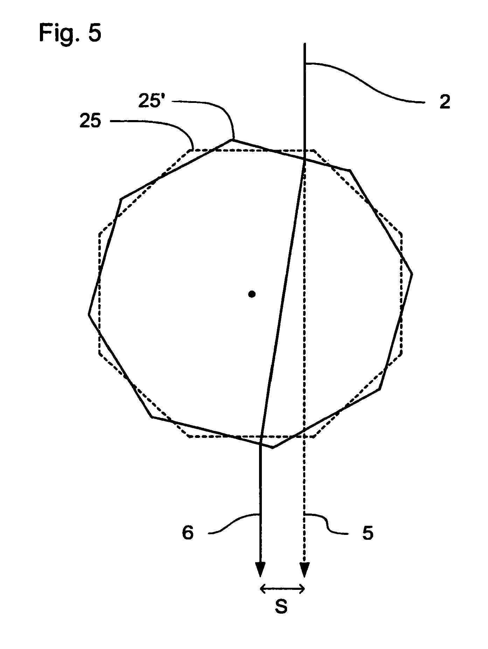

Alternatively, a transparent rotating prism 25 may be used, as shown in Figure 5. In this case, the prism may be located in the imaging plane.

Errors caused by the movement of the substrate during a pulse of radiation are reduced by providing means to shift the patterned projection beam in synchronism with the movement of the substrate during a pulse of radiation. Alternative means of shifting the patterned projection beam may be within the scope of the invention.

Whilst specific embodiments of the invention have been described above, it will be appreciated that the invention may be practiced otherwise than as described. The description is not intended to limit the invention which is defined by the claims.

**Claims**

1. A lithographic projection apparatus comprising:

   - a radiation system (LA,IL) for providing a pulsed projection beam (PB) of radiation;
   - programmable patterning means (PPM) for patterning the projection beam according to a desired pattern;
   - a projection system (PL) for projecting the patterned beam onto a target portion (C) of a substrate (VV); and
   - means configured to move the substrate (W) relative to the projection system;

   means (4;15;25) configured to move the patterned projection beam (2) that is projected onto the substrate (W) relative to the projection system (PL), **characterized in that** the apparatus is arranged such that the patterned projection beam moves in synchronism with the movement of the substrate during at least one pulse of the radiation system such that the patterned projection beam is substantially stationary relative to the substrate during said at least one pulse.

2. A lithographic projection apparatus according to claim 1, wherein the substrate is moved at a substantially constant velocity relative to the projection system during the course of a plurality of pulses of the radiation system and the intervals therebetween; and the patterned projection beam is moved in synchronism with the movement of the substrate for the duration of at least one pulse of the radiation system.

3. A lithographic projection apparatus according to claim 2, wherein the patterned projection beam (2) is moved in synchronism with the movement of the substrate (W) during a plurality of pulses of the radiation system (LA,IL) such that the image of the programmable patterning means (PPM) is projected onto substantially the same place on the substrate a plurality of times.

4. A lithographic projection apparatus according to claim 3, wherein the pattern provided to the programmable patterning means (PPM) is changed between successive pulses of the radiation system (LA,IL) that are projected onto substantially the same place on the substrate (W).

5. A lithographic projection apparatus according to claim 3 or 4, wherein at least one of the intensity of the patterned projection beam (2), the illumination of the programmable patterning means (PPM) and the pupil filtering are changed for at least one of said pulses of the radiation system (LA,IL) that are projected onto substantially the same place on the substrate (W).

6. A lithographic projection apparatus according to any one of the preceding claims, wherein the means (4) configured to move the patterned projection beam (2) relative to the projection system (PL) comprises: a layer of electro-optical material through which the patterned projection beam passes and a control system for providing a control voltage across the electro-optical material; and where adjusting said control voltage changes the birefringence of the electro-optical material, moving at least a part of the patterned projection beam emitted from it.

7. A lithographic projection apparatus according to claim 6, wherein the patterned projection beam (2) is polarized and the direction of the optical axis of the electro-optical material is oriented such that substantially all of the projection beam is moved.

8. A lithographic projection apparatus according to claim 6, wherein the means (4) configured to move the patterned projection beam (2) relative to the projection system (PL) comprises a second layer (8) of electro-optical material through which the patterned projection beam passes and to which the control system provides a control voltage to change its birefringence; and wherein the direction of the optical axis of the second layer of electro-optical material is substantially perpendicular to that of the first layer, such that changing the birefringence of both layers moves substantially all of the projection beam.

9. A lithographic projection apparatus according to any one of claims 1 to 5, wherein the means (15) configured to move the patterned projection beam(2) relative to the projection system (PL) comprises: a reflective surface (16) mounted such that the angle between the surface and the patterned projection beam incident upon it varies during said pulse of the radiation.

10. A lithographic projection apparatus according to any one of claims 1 to 5, wherein the means (25) configured to move the patterned projection beam (2) relative to the projection system (PL) comprises: an element that is transmissive to the beam of radiation, mounted such that the angle between the radiation beam and the surface on which it is incident varies during said pulse of radiation.

11. A lithographic projection apparatus according to claim 9 or 10, wherein said means (15,25) configured to move the patterned projection beam (2) relative to the projection system (PL) comprises a rotating prism, the end faces of which are polygonal; and wherein at least one longitudinal face is the surface on which the patterned projection beam (2) is incident during said pulse of the radiation system.

12. A lithographic projection apparatus according to any one of the preceding claims, further comprising a substrate table (WT) for holding the substrate (W).

13. A device manufacturing method comprising the steps of:

- providing a substrate (W) that is at least partially covered by a layer of radiation sensitive material;
- providing a pulsed projection beam (PB) of radiation using a radiation system (LA,IL);
- using programmable patterning means (PPM) to endow the projection beam with a pattern in its cross-section;
- projecting the patterned beam (2) of radiation onto a target portion (C) of the layer of radiation-sensitive material; and
- moving the substrate (W) relative to the projection system (PL) to target successive portions of the layer of radiation-sensitive material;

**characterized by** moving the patterned projection beam (2) that is projected onto the substrate (W) relative to the projection system (PL) during at least one pulse of the radiation system in synchronism with the movement of the substrate such that the projection beam is substantially stationary relative to the substrate during said at least one pulse.

## Patentansprüche

1. Ein lithographischer Projektionsapparat, aufweisend:

- ein Strahlungssystem (LA, IL) zur Bereitstellung eines Projektionsstrahls (PB) einer Strahlung;
- programmierbare Musterungsmittel (PPM) zur Musterung des Projektionsstrahls gemäß einem gewünschten Muster;
- ein Projektionssystem (PL) zum Projizieren des gemusterten Strahls auf einen Zielabschnitt (C) eines Substrats (W);
- Mittel, die das Substrat (W) relativ zu dem Projektionssystem zu bewegen vermögen; und
- Mittel (4; 15; 25), die den gemusterten Projektionsstrahl (2), der auf das Substrat (W) projiziert wird, relativ zu dem Projektionssystem (PL) zu bewegen vermögen,

**dadurch gekennzeichnet, dass** der Apparat so aufgebaut ist, dass sich der gemusterte Projektionsstrahl synchron mit der Bewegung des Substrats während wenigstens eines Impulses des Strahlungssystems derart bewegt, dass der gemusterte Projektionsstrahl während des wenigstens einen Impulses zu dem Substrat im wesentlichen ortsfest ist.

2. Ein lithographischer Projektionsapparat nach Anspruch 1, bei dem das Substrat während des Verlaufs einer Mehrzahl von Impulsen des Strahlungssystems und den dazwischen liegenden Intervallen mit einer im wesentlichen konstanten Geschwindigkeit relativ zu dem Projektionssystem bewegt wird; und wobei während der Dauer wenigstens eines Impulses des Strahlungssystems der gemusterte Projektionsstrahl synchron mit der Bewegung des Substrats bewegt wird.

3. Ein lithographischer Projektionsapparat nach Anspruch 2, bei dem der gemusterte Projektionsstrahl (2) während einer Mehrzahl von Impulsen des Strahlungssystems (LA, IL) synchron mit der Bewegung des Substrats (W) derart bewegt wird, dass das Bild der programmierbaren Musterungsmittel (PPM) mehrfach im wesentlichen auf den gleichen Ort auf dem Substrat projiziert wird.

4. Ein lithographischer Projektionsapparat nach Anspruch 3, bei dem das den programmierbaren Musterungsmitteln (PPM) bereitgestellte Muster zwischen aufeinander folgenden Impulsen des Strahlungssystems (LA, IL), die im wesentlichen auf den gleichen Ort auf dem Substrat (W) projiziert werden, geändert wird.

5. Ein lithographischer Projektionsapparat nach Anspruch 3 oder 4, bei dem wenigstens entweder die Intensität des gemusterten Projektionsstrahls (2) oder die Beleuchtung der programmierbaren Musterungsmittel (PPM) und die Pupillenfilterung für wenigstens einen der Impulse des Strahlungssystems (LA, IL),), die im wesentlichen auf den gleichen Ort auf dem Substrat (W) projiziert werden, geändert wird.

6. Ein lithographischer Projektionsapparat nach einem der vorhergehenden Ansprüche, bei dem die Mittel (4), die den gemusterten Projektionsstrahl (2) relativ zu dem Projektionssystem (PL) zu bewegen vermögen, aufweisen: eine Schicht eines elektro-optischen Materials, durch welche der gemusterte Projektionsstrahl läuft; und ein Steuersystem zur Anlegung einer Steuerspannung an das elektro-optische Material, wobei eine Einstellung der Steuerspannung die Doppelbrechung des elektro-optischen Materials ändert, was wenigstens einen Teil des hiervon emittierten gemusterten Projektionsstrahls bewegt.

7. Ein lithographischer Projektionsapparat nach Anspruch 6, bei dem der gemusterte Projektionsstrahl (2) polarisiert ist und die Richtung der optischen Achse des elektro-optischen Materials so ausgerichtet ist, dass im wesentlichen der gesamte Projektionsstrahl bewegt wird.

8. Ein lithographischer Projektionsapparat nach Anspruch 6, bei dem die Mittel (4), die den gemusterten Projektionsstrahl (2) relativ zu dem Projektionssystem (PL) zu bewegen vermögen, eine zweite Schicht (8) eines elektro-optischen Materials aufweisen, welche der gemusterte Projektionsstrahl durchläuft und an welche das Steuersystem eine Steuerspannung liefert, um ihre Doppelbrechung zu ändern, wobei die Richtung der optischen Achse der zweiten Schicht aus elektro-optischem Material im wesentlichen senkrecht zu der ersten Schicht ist, so dass eine Änderung der Doppelbrechung beider Schichten im wesentlichen den gesamten Projektionsstrahl bewegt.

9. Ein lithographischer Projektionsapparat nach einem der Ansprüche 1 bis 5, bei dem die Mittel (15), die den gemusterten Projektionsstrahl (2) relativ zu dem Projektionssystem (PL) zu bewegen vermögen, aufweisen: eine reflektierende Oberfläche (16), die so angeordnet ist, dass der Winkel zwischen der Oberfläche und dem gemusterten Projektionsstrahl; der hierauf fällt, sich während des Impulses der Strahlung ändert.

10. Ein lithographischer Projektionsapparat nach einem der Ansprüche 1 bis 5, bei dem die Mittel (25), die den gemusterten Projektionsstrahl (2) relativ zu dem Projektionssystem (PL) zu bewegen vermögen, aufweisen: ein Element, das für den Strahl der Strahlung durchlässig ist und das so angeordnet ist, dass der Winkel zwischen dem Strahlungsstrahl und der Oberfläche, auf die er fällt, sich während des Impulses der Strahlung ändert.

11. Ein lithographischer Projektionsapparat nach Anspruch 9 oder 10, bei dem die Mittel (15, 25), die den gemusterten Projektionsstrahl (2) relativ zu dem Projektionssystem (PL) zu bewegen vermögen, ein sich drehendes Prisma, dessen Endflächen polygonal sind, aufweist, wobei wenigstens eine Längsfläche die Oberfläche ist, auf welche der gemusterte Projektionsstrahl (2) während des Impulses der Strahlungssystems fällt.

12. Ein lithographischer Projektionsapparat nach einem der vorhergehenden Ansprüche, weiterhin mit einem Substrattisch (WT) zum Halten des Substrats (W).

13. Ein Verfahren zur Herstellung einer Vorrichtung, aufweisend die Schritte von:

   - Bereitstellen eines Substrats (W), das zumindest teilweise mit einer Schicht aus strahlungsempfindlichen Material bedeckt ist;
   - Bereitstellen eines gepulsten Projektionsstrahls (PB) einer Strahlung unter Verwendung eines Strahlungssystems (LA, IL);

- Verwenden programmierbarer Musterungsmittel (PPM), um den Projektionsstrahl in seinem Querschnitt mit einem Muster zu versehen;
- Projizieren des gemusterten Strahls (2) der Strahlung auf einen Zielabschnitt (C) der Schicht aus dem strahlungsempfindlichen Material; und
- Bewegen des Substrats (W) relativ zu dem Projektionssystem (PL), um aufeinander folgende Abschnitte der Schicht aus strahlungsempfndlichem Material anzuzielen,

**gekennzeichnet durch** Bewegen des gemusterten Projektionsstrahls (2), der auf das Substrat (W) projiziert wird, relativ zu dem Projektionssystem (PL) während wenigstens eines Impulses des Strahlungssystems synchron mit der Bewegung des Substrats derart, dass der Projektionsstrahl während des wenigstens einen Impulses zu dem Substrat im wesentlichen ortsfest ist.

## Revendications

1.  Appareil de projection lithographique comprenant :

    - un système de rayonnement (LA, IL) pour fournir un faisceau de projection pulsé (PB) de rayonnement ;
    - des moyens programmables de mise en forme (PPM) pour mettre en forme le faisceau de projection conformément à un motif voulu ;
    - un système de projection (PL) pour projeter le faisceau mis en forme sur une partie cible (C) d'un substrat (M) ; et
    - des moyens configurés pour déplacer le substrat (W) par rapport au système de projection ;
    - des moyens (4 ; 15 ; 25) configurés pour déplacer le faisceau de projection mis en forme (2) qui est projeté sur le substrat (W) par rapport au système de projection (PL),

    **caractérisé en ce que** l'appareil est agencé de sorte que le faisceau de projection mis en forme se déplace en synchronisation avec le déplacement du substrat pendant au moins une impulsion du système de rayonnement de sorte que le faisceau de projection mis en forme soit sensiblement stationnaire par rapport au substrat pendant ladite au moins une impulsion.

2.  Appareil de projection lithographique selon la revendication 1, dans lequel le substrat est déplacé à une vitesse sensiblement constante par rapport au système de projection au cours d'une pluralité d'impulsions du système de rayonnement et des intervalles entre celles-ci ; et le faisceau de projection mis en forme est déplacé en synchronisation avec le déplacement du substrat pendant la durée d'au moins une impulsion du système de rayonnement.

3.  Appareil de projection lithographique selon la revendication 2, dans lequel le faisceau de projection mis en forme (2) est déplacé en synchronisation avec le déplacement du substrat (W) pendant une pluralité d'impulsions du système de rayonnement (LA, IL) de telle sorte que l'image des moyens programmables de mise en forme (PPM) est projetée plusieurs fois sensiblement sur le même emplacement sur le substrat.

4.  Appareil de projection lithographique selon la revendication 3, dans lequel le motif fourni aux moyens programmables de mise en forme (PPM) est changé entre des impulsions successives du système de rayonnement (LA, IL) qui sont projetées sensiblement sur le même emplacement sur le substrat (W).

5.  Appareil de projection lithographique selon la revendication 3 ou 4, dans lequel au moins l'un de l'intensité du faisceau de projection muni d'un motif (2), de l'éclairage des moyens programmables de mise en forme (PPM) et du filtrage pupillaire sont changés pendant au moins une desdites impulsions du système de rayonnement (LA, IL) qui sont projetées sensiblement sur le même emplacement sur le substrat (W).

6.  Appareil de projection lithographique selon l'une quelconque des revendications précédentes, dans lequel les moyens (4) configurés pour déplacer le faisceau de projection mis en forme (2) par rapport au système de projection (PL) comprennent : une couche de matériau électro-optique à travers laquelle passe le faisceau de projection mis en forme et un système de commande pour fournir une tension de commande à travers le matériau électro-optique ; et où l'ajustement de ladite tension de commande change la biréfringence du matériau électro-optique, déplaçant au moins une partie du faisceau de projection mis en forme émis à partir de celui-ci.

7.  Appareil de projection lithographique selon la revendication 6, dans lequel le faisceau de projection mis en forme (2) est polarisé et la direction de l'axe optique du matériau électro-optique est orientée de telle sorte que sensiblement la totalité du faisceau de projection est déplacée.

8. Appareil de projection lithographique selon la revendication 6, dans lequel les moyens (4) configurés pour déplacer le faisceau de projection mis en forme (2) par rapport au système de projection (PL) comprennent une seconde couche (8) de matériau électro-optique à travers laquelle passe le faisceau de projection mis en forme et à laquelle le système de commande fournit une tension de commande pour changer sa biréfringence ; et dans lequel la direction de l'axe optique de la seconde couche de matériau électro-optique est sensiblement perpendiculaire à celui de la première couche, de sorte que le changement de la biréfringence des deux couches déplace sensiblement la totalité du faisceau de projection.

9. Appareil de projection lithographique selon l'une quelconque des revendications 1 à 5, dans lequel les moyens (15) configurés pour déplacer le faisceau de projection mis en forme (2) par rapport au système de projection (PL) comprennent : une surface réflectrice (16) montée de telle sorte que l'angle entre la surface et le faisceau de projection mis en forme, incident sur celle-ci, varie pendant ladite impulsion du rayonnement.

10. Appareil de projection lithographique selon l'une quelconque des revendications 1 à 5, dans lequel les moyens (25) configurés pour déplacer le faisceau de projection mis en forme (2) par rapport au système de projection (PL) comprennent : un élément qui est transmetteur par rapport au faisceau de rayonnement, monté de telle sorte que l'angle entre le faisceau de rayonnement et la surface sur laquelle il est incident varie pendant ladite impulsion de rayonnement.

11. Appareil de projection lithographique selon la revendication 9 ou 10, dans lequel lesdits moyens (15, 25) configurés pour déplacer le faisceau de projection mis en forme (2) par rapport au système de projection (PL) comprennent un prisme rotatif, dont les faces d'extrémité sont polygonales ; et dans lequel au moins une face longitudinale est la surface sur laquelle le faisceau de projection mis en forme (2) est incident pendant ladite impulsion du système de rayonnement.

12. Appareil de projection lithographique selon l'une quelconque des revendications précédentes, comprenant de plus une table de substrat (WT) pour supporter le substrat (W).

13. Procédé de fabrication d'un dispositif, comprenant les étapes suivantes :

- fournir un substrat (W) qui est au moins partiellement recouvert d'une couche de matériau sensible au rayonnement ;
- fournir un faisceau de projection pulsé (PB) d'un rayonnement en utilisant un système de rayonnement (LA, IL) ;
- utiliser des moyens programmables de mise en forme (PPM) pour doter le faisceau de projection d'un motif dans sa section transversale ;
- projeter le faisceau de rayonnement mis en forme (2) sur une partie cible (C) de la couche de matériau sensible au rayonnement ; et
- déplacer le substrat (W) par rapport au système de projection (PL) vers des parties cibles successives de la couche de matériau sensible au rayonnement ;

**caractérisé en ce qu'**on déplace le faisceau de projection mis en forme (2) qui est projeté sur le substrat (W) par rapport au système de projection (PL) pendant au moins une impulsion du système de rayonnement en synchronisation avec le déplacement du substrat de telle sorte que le faisceau de projection soit sensiblement stationnaire par rapport au substrat pendant ladite au moins une impulsion.

# Fig. 1

1

PPM

IL AM IN CO PB

LA → Ex → [ IL AM IN CO ] → PB

PL

W

P1    P2

IF

BP

WT    PW

Y ⊙ → X

**Fig. 2**

**Fig. 3**

## Fig. 4

# Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6379867 B
- US 5296891 A
- US 5523193 A
- WO 9838597 A
- WO 9833096 A
- US 5229872 A

**Non-patent literature cited in the description**

- **PETER VAN ZANT.** Microchip Fabrication: A Practical Guide to Semiconductor Processing. McGraw Hill Publishing Co, 1997